Europäisches Patentamt

European Patent Office

Office européen des brevets

(19)

(11) EP 0 536 042 B1

(12) FASCICULE DE BREVET EUROPEEN

(45) Date de publication et mention
de la délivrance du brevet:
**24.04.1996 Bulletin 1996/17**

(51) Int Cl.6: **H03L 7/095**, H03L 7/199

(21) Numéro de dépôt: **92402670.1**

(22) Date de dépôt: **29.09.1992**

(54) **Dispositif de détection d'accrochage d'une boucle à verrouillage de phase numérique**

Verriegelungsdetektor eines digitalen Phasenregelkreises

Phase lock detection device for a digital PLL

(84) Etats contractants désignés:
**AT BE CH DE ES FR GB IT LI NL SE**

(30) Priorité: **04.10.1991 FR 9112267**

(43) Date de publication de la demande:
**07.04.1993 Bulletin 1993/14**

(73) Titulaire: **ALCATEL CIT
F-75008 Paris (FR)**

(72) Inventeur: **Lafon, Jean-Luc
F-94170 Le Perreux sur Marne (FR)**

(74) Mandataire: **El Manouni, Josiane et al
SOSPI
14-16, rue de la Baume
F-75008 Paris (FR)**

(56) Documents cités:
EP-A- 0 349 966        EP-A- 0 433 120
WO-A-81/02497          WO-A-87/01885

## Description

La présente invention est du domaine du traitement des signaux numériques. Elle concerne plus particulièrement les dispositifs appelés boucles à verrouillage de phase numériques.

De tels dispositifs sont bien connus ; on rappelle simplement qu'ils sont utilisés pour asservir la phase d'un signal numérique dit sortant, fourni par cette boucle, à celle d'un signal numérique dit entrant, reçu par cette boucle, et qu'ils procèdent essentiellement par incrémentation, ou décrémentation, de la fréquence d'un signal d'horloge fourni par un oscillateur interne à cette boucle, en fonction de l'écart de phase existant entre lesdits signaux entrant et sortant. Le signal de commande d'incrémentation ou de décrémentation de la fréquence du signal d'horloge fourni par ledit oscillateur est fourni par la sortie dite de débordement d'un compteur qui est déclenché par un signal représentatif dudit écart de phase, et qui compte au rythme d'un signal d'horloge également fourni par ledit oscillateur interne.

L'invention s'applique particulièrement à la synchronisation d'un terminal de télécommunications raccordé à un réseau de télécommunication à transfert en mode asynchrone, par l'intermédiaire d'un dispositif dit adaptateur permettant de restituer vis-à-vis de ce terminal, une interface synchrone, un tel dispositif adaptateur utilisant en effet une boucle à verrouillage de phase numérique pour générer un signal d'horloge de fréquence moyenne égale à la fréquence de base de ladite interface synchrone, et dont la phase est asservie à celle d'un signal d'horloge entrant de rythme égal au rythme des données reçues de ce réseau par ce dispositif adaptateur.

Une telle application requiert en effet simultanément, à l'établissement d'une communication interessant ce terminal, un temps d'accrochage relativement court de cette boucle et un filtrage relativement important afin de satisfaire aux conditions généralement sévères imposées par la norme régissant une telle interface, sur la gigue maximale admissible pour ledit signal d'horloge de fréquence moyenne égale à la fréquence de base de ladite interface synchrone.

Pour une telle application, dans laquelle le signal d'entrée de ladite boucle est présent par intermittence, avec un état de phase quelconque d'une présence à l'autre, on peut être amené à utiliser un procédé de commande de mode de fonctionnement d'une telle boucle, comportant dans l'ordre, les étapes suivantes :

- détection d'un début de présence dudit signal d'entrée,
- sélection d'une plage de comptage dudit compteur ayant une valeur relativement faible en vue de permettre un accrochage relativement rapide de ladite boucle,
- détection d'accrochage de ladite boucle,
- sélection d'une plage de comptage dudit compteur ayant une valeur relativement forte, en vue de filtrer relativement fortement les éventuelles variations de phase dudit signal d'entrée se produisant au cours de ladite présence, ce dernier réglage étant conservé jusqu'à la prochaine détection d'un début de présence du signal d'entrée.

La présente invention a pour but de réaliser un dispositif qui permette une telle détection d'accrochage.

La présente invention a pour objet un dispositif de détection d'accrochage d'une boucle à verrouillage de phase numérique, ladite boucle comportant un détecteur d'écart de-phase entre ledit signal entrant et ledit signal sortant, le signal de sortie de ce détecteur de phase présentant des transitions d'un premier type en coïncidence avec les transitions d'un type donné du signal sortant, et des transitions d'un second type en coïncidence avec les transitions d'un type donné du signal entrant, essentiellement caractérisé en ce que ce dispositif comporte des moyens de détection d'accrochage comportant eux-mêmes des moyens pour réaliser un échantillonnage du signal de sortie du détecteur de phase, par celles des transitions du signal sortant qui sont de type opposé audit type donné et pour mémoriser des groupes d'échantillons consécutifs ainsi obtenus, en ncmbre au moins égal à 3, et des moyens de détection de l'instant où, pour la première fois, deux au moins desdits échantillons n'ont pu le même niveau logique.

D'autres objets et caractéristiques de la présente invention apparaîtront à la lecture de la description suivante d'un exemple de réalisation, faite en relation avec les dessins ci-annexés dans lesquels :

- la figure 1 est un schéma synoptique illustrant l'application d'un dispositif suivant l'invention à la commande de mode de fonctionnement d'une boucle à verrouillage de phase numérique, telle que définie plus haut,
- la figure 2 est un schéma de réalisation possible des moyens, suivant l'invention, de détection d'accrochage de boucle à verrouillage de phase, et des moyens de commande de sélection de plage de comptage, intervenant dans ce dispositif de commande,

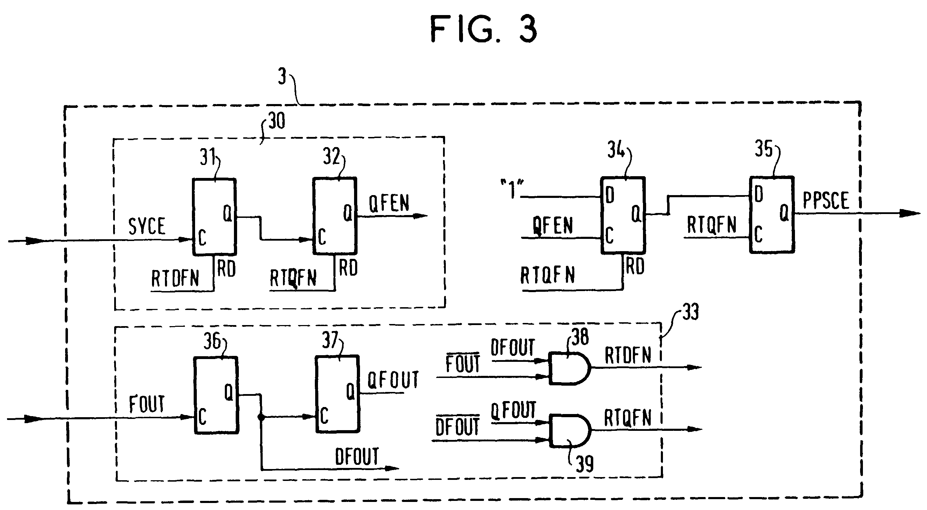

- la figure 3 est un schéma de réalisation possible des moyens de détection d'un début de présence de signal entrant, intervenant dans ce dispositif de commande,
- la figure 4 est un chronogramme destiné à illustrer ladite commande de sélection de plage de comptage.

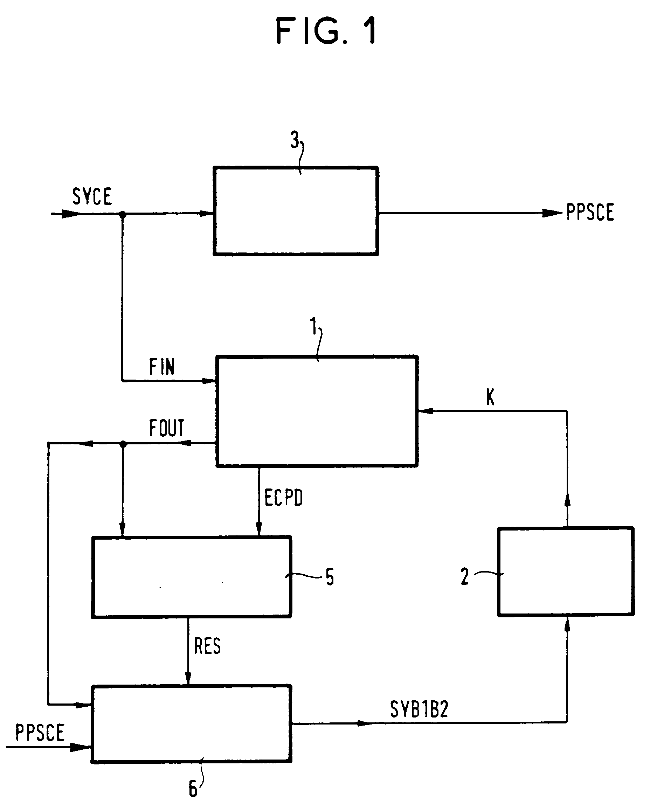

Sur la figure 1 est référencée 1 une boucle à verrouillage de phase numérique qui est par exemple d'ordre égal à 1. Cette boucle à verrouillage de phase, dont la constitution interne n'est pas rappelée sur cette figure, reçoit un signal dit entrant, noté FIN, et fournit un signal dit sortant, noté FOUT. Cette boucle reçoit en outre, via un moyen 2 de sélection de coefficient, un coefficient K de commande de la plage de comptage de son compteur de commande d'incrémentation ou de décrémentation, et fournit en outre un signal, noté ECPD, de sortie de son détecteur de phase.

Ce détecteur de phase est en l'occurrence un détecteur dit à commande par les transitions des signaux qui lui sont appliqués, et on considérera, par exemple, dans ce qui suit, qu'une transition descendante du signal FOUT provoque un passage à un niveau haut de ce signal ECPD, et qu'une transition descendante consécutive du signal FIN provoque un passage à un niveau bas de ce signal ECPD.

Sur la figure 1 est en outre référencé 3 un moyen de détection d'un début de présence de signal entrant. Dans le cas de l'exemple d'application rappelé plus haut, à la synchronisation d'un terminal de télécommunications raccordé à un réseau de télécommunications à transfert en mode asynchrone, le signal entrant, lorsqu'il est présent, est formé d'une suite de cellules, ou paquets de longueur fixe, les cellules d'une même suite étant relatives à une même communication établie via un tel réseau. Les suites de cellules ainsi obtenues sont alors présentes de façon intermittente, au gré des apparitions et des disparitions de communications intéressant le terminal considéré.

Le moyen de détection 3 reçoit un signal numérique noté SYCE dont le rythme est constitué par le rythme d'arrivée de ces cellules, ce signal constituant, pour la boucle à verrouillage de phase, le signal d'entrée FIN de cette boucle.

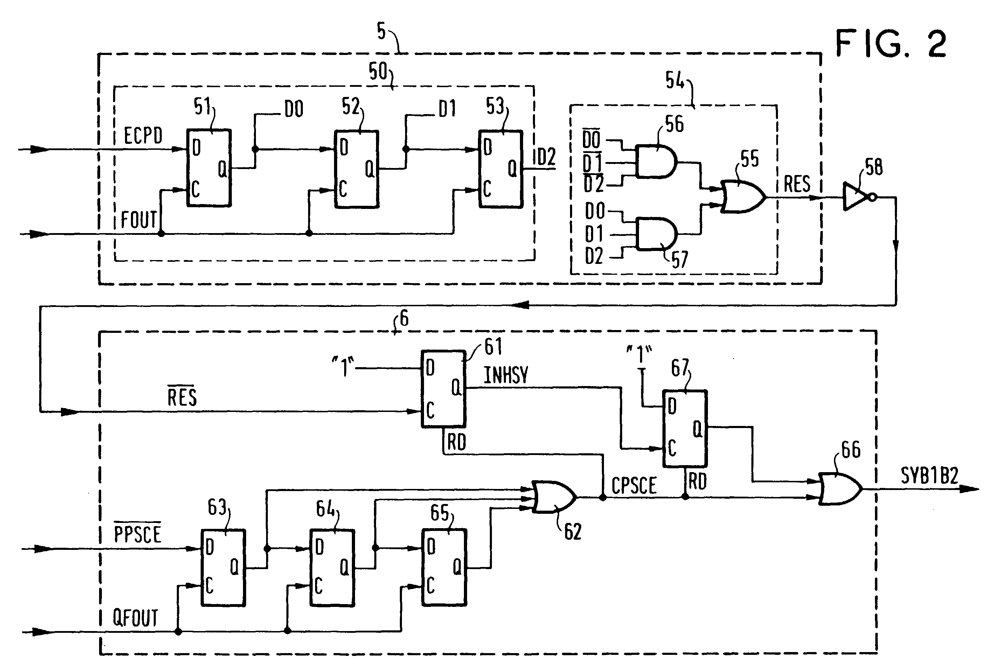

Sur la figure 1 est en outre référencé 5 un moyen de détection d'accrochage de la boucle à verrouillage de phase 1, qui opère à partir des signaux ECPD et FOUT d'une façon qui sera décrite ultérieurement en relation avec la figure 2, et 6 un moyen de commande du moyen 2 de sélection de coefficient, qui opère à partir du signal RES fourni par le moyen 5 et à partir des signaux PPSCE et FOUT, d'une façon qui sera décrite ultérieurement en relation avec la figure 2, pour fournir un signal, noté SYB1B2, de commande de ce moyen 2 de sélection de coefficient.

Le moyen 5 de détection d'accrochage comporte, selon cette figure 2, des moyens 50 d'échantillonnage du signal ECPD par le signal FOUT et de mémorisation d'un certain nombre, égal ici à trois mais qui pourrait être supérieur à cette valeur, d'échantillons consécutifs ainsi obtenus.

Ces moyens 50 comportent en l'occurrence trois bascules du type D, 51, 52, 53 dont l'entrée d'horloge, référencée C, reçoit le signal FOUT, l'entrée "D" de la bascule 51 recevant le signal ECPD, l'entrée "D" de la bascule 52 le signal D0 fourni par la sortie "Q" de la bascule 51, et l'entrée D de la bascule 53 le signal D1 fourni par la sortie Q de la bascule 52, le signal fourni par la sortie Q de la bascule 53 étant en outre référencé D2.

Le moyen 5 de détection d'accrochage comporte également un circuit 54 de détection de valeurs non identiques de deux des échantillons mémorisés dans les moyens 50.

Ce circuit 54 comporte en l'occurrence une porte "OU" 55 dont une première entrée reçoit le signal de sortie d'une porte ET 56 recevant les signaux D0, D1 et D2 inversés, notés $\overline{D0}$, $\overline{D1}$, $\overline{D2}$, et dont une deuxième entrée reçoit le signal de sortie d'une porte ET 57 recevant les signaux D0, D1 et D2.

Le signal de sortie de la porte OU 55 constitue le signal RES de sortie des moyens de détection d'accrochage.

L'invention utilise en effet la propriété qu'a le signal ECPD de sortie d'un détecteur de phase dit à commande par les transitions des signaux qui lui sont appliqués de conduire à l'obtention de deux tels échantillons de niveaux opposés, entourant un instant d'accrochage dit idéal, non accessible en pratique du fait que la boucle procède par incréments ou décréments de fréquence, c'est-à-dire par variation, de façon discontinue, et non de façon continue, de cette fréquence.

L'instant d'accrochage ainsi détecté par les moyens 5 est alors obtenu lorsque, parmi les trois échantillons ainsi mémorisés, deux d'entre eux ont pour la première fois, des niveaux opposés.

En pratique, le signal ECPD vérifiant une telle propriété relativement fréquemment une fois l'accrochage réalisé, et relativement peu fréquemment avant que cet accrochage ne soit réalisé, le signal RES n'est pas exploité tel quel par les moyens 2 de sélection de coefficient de la figure 1, mais après traitement, dans un circuit 6, de la façon maintenant décrite.

Un signal, référencé INHSY, est tout d'abord fabriqué au moyen d'une bascule "D" 61 qui reçoit sur son entrée D un niveau logique "1" et sur son entrée d'horloge un signal, noté $\overline{RES}$, obtenu par inversion du signal RES au moyen d'un inverseur 58.

La bascule 61 reçoit en outre sur son entrée de remise à zéro, notée RD, un signal, noté CPSCE, élaboré de la façon suivante.

Ce signal CPSCE est obtenu en sortie d'une porte OU 62 munie de trois entrées connectées respectivement à la sortie Q de trois bascules 63, 64, 65 connectées en cascade, c'est-à-dire avec la sortie Q de la première d'entre elles, 63, connectée à l'entrée D de la deuxième d'entre elles, 64, et la sortie Q de cette deuxième bascule connectée à l'entrée D de la troisième bascule, 65.

L'entrée D de la première bascule 63 reçoit en outre le signal PPSCE inversé, noté $\overline{PPSCE}$, et l'entrée d'horloge de ces trois bascules reçoit un signal QFOUT de fréquence égale au quart de la fréquence du signal FOUT.

Le signal INHSY permet ainsi de ne prendre en compte, à titre de premier basculement du signal RES, correspondant à l'accrochage, que celui des basculements de ce signal qui intervient pour la première fois au bout d'une certaine durée après une détection de début de présence de signal d'entrée, cette durée correspondant en l'occurrence à quatre périodes du signal FOUT.

Le signal SYB1B2 de commande de sélection de coefficient est obtenu en sortie d'une porte OU 66 munie de deux entrées qui reçoivent respectivement le signal CPSCE, et le signal fourni par la sortie Q d'une bascule "D" 67 dont l'entrée "D" reçoit un niveau logique "1", dont l'entrée d'horloge reçoit le signal INHSY, et dont l'entrée de remise à zéro reçoit le signal CPSCE.

Ainsi lorsque l'on se situe entre une détection de début de présence de signal d'entrée et une détection d'accrochage, le signal SYB1B2 a un premier niveau logique conduisant à la sélection d'une première valeur de coefficient, correspondant à une plage de comptage relativement faible afin de réduire la durée d'accrochage, et lorsque l'on se situe après une détection d'accrochage, ou en l'absence de signal d'entrée FIN, le signal SYB1B2 a un second niveau logique conduisant à la sélection d'une deuxième valeur de coefficient, correspondant à une plage de comptage relativement forte afin de filtrer efficacement les variations de phase du signal d'entrée FIN.

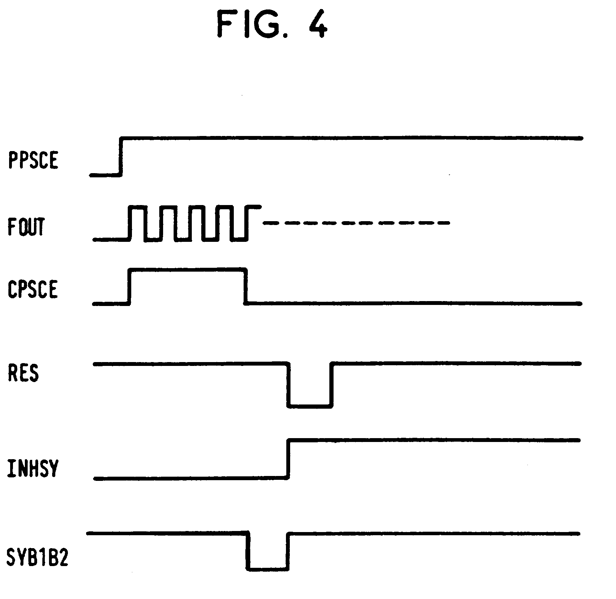

La figure 4 représente un chronogramme destiné à illustrer ce mode de sélection de plage de comptage. Sur la première ligne de ce chronogramme on a représenté le signal PPSCE dont le passage du niveau logique 0 au niveau logique 1 indique une détection de début de présence de signal d'entrée.

A la deuxième ligne de ce chronogramme est représenté le signal FOUT.

A la troisième ligne de ce chronogramme est représenté le signal CPSCE qui prend un niveau logique "1" à la première transition du signal FOUT intervenant après la transition du signal PPSCE, et qui conserve dans cet exemple ce niveau logique "1" pendant quatre périodes consécutives du signal FOUT.

A la quatrième ligne de ce chronogramme est représenté le signal RES qui présente une transition descendantes correspondant à un accrochage de la boucle à verrouillage de phase. cette transition descendante est en pratique suivie d'une transition montante, comme illustré sur ce chronogramme.

A la cinquième ligne de ce chronogramme est illustré le signal INHSY qui passe du niveau logique "0" au niveau logique "1" à cette transition descendante du signal RES et qui conserve ensuite ce niveau logique "1" tant que le signal CPSCE conserve le niveau logique "0".

A la dernière ligne de ce chronogramme est représenté le signal SYB1B2 de commande de sélection de coefficients.

Quand le signal CPSCE passe au niveau logique 1 il remet au niveau logique 0 les sorties Q des bascules 61 et 67. Le signal SYB1B2 passe au niveau logique 0 lorsque le signal CPSCE repasse au niveau logique 0. Puis le signal SYB1B2 passe au niveau logique 1, le signal CPSCE étant au niveau logique 0.

Les moyens 3 de détection de début de présence de signal d'entrée procèdent essentiellement par division par "n" du rythme du signal incident SYCE, de façon à compter "n" cellules incidentes successives, et par prise en compte du résultat de ce comptage à un rythme dérivé en l'occurrence du signal sortant FOUT, et obtenu par division par la même valeur "n" du rythme de ce signal FOUT.

Dans l'exemple illustré sur la figure 2, le nombre "n" a été choisi égal à 4. Ces moyens de détection comportent ainsi un compteur par "n", 30, formé de deux bascules 31 et 32 mises en cascade, c'est-à-dire avec la sortie Q de la première bascule 31 reliée à l'entrée d'horloge de la deuxième bascule 32. L'entrée d'horloge de la bascule 31 reçoit en outre le signal de rythme incident SYCE et le signal de sortie de la bascule 32 est noté QFEN. Ces deux bascules 31 et 32 sont remises à zéro respectivement par un signal RTDFN et par signal RTQFN élaboré par un générateur 33 de signaux d'horloge dérivés du signal FOUT.

Le signal QFEN issu du compteur 30 est appliqué à l'entrée d'horloge d'une bascule du type "D" 34 dont l'entrée D est mise au niveau logique "1".

La sortie Q de la bascule 34 est reliée à l'entrée D d'une bascule 35 dont l'entrée d'horloge reçoit un signal RTQFN délivré par le générateur 33. La sortie Q de la bascule 35 fournit le signal PPSCE d'indication d'un début de présence du signal d'entrée.

La bascule 34 reçoit également sur son entrée de remise à zéro le signal RTQFN fourni par le générateur 33.

Le générateur 33 comporte dans cet exemple un diviseur de fréquence par quatre, comportant deux bascules 36 et 37 montées en cascade de façon analogue aux bascules 31 et 32. La bascule 36 reçoit en outre sur son entrée d'horloge le signal FOUT et fournit sur sa sortie Q un signal noté DFOUT, et la bascule 37 fournit sur sa sortie Q un signal noté QFOUT.

Le générateur 33 comporte en outre une porte ET 30 qui reçoit le signal DFOUT et le signal FOUT inversé, noté $\overline{FOUT}$, et qui fournit le signal RTDFN.

Le générateur 33 comporte également une porte ET 39 qui reçoit le signal QFOUT et le signal DFOUT inversé, noté $\overline{DFOUT}$, et qui fournit le signal RTQFN.

Bien que la description qui précède de la présente invention ait été faite plus particulièrement, à titre d'exemple, dans le cadre de son application à une commande de mode de fonctionnement d'une boucle à verrouillage de phase numérique, telle que définie plus haut, on comprendra que la présente invention n'est pas limitée à cette application particulière et peut avoir, en pratique de multiples applications.

**Revendications**

1. Dispositif de détection d'accrochage d'une boucle à verrouillage de phase numérique, ladite boucle à verrouillage de phase (1) comportant un détecteur d'écart de phase entre le signal entrant et le signal sortant, et le signal de sortie de ce détecteur d'écart de phase présentant des transitions d'un premier type en coïncidence avec les transitions d'un type donné du signal sortant, et des transitions d'un second type en coïncidence avec les transitions d'un type donné du signal entrant caractérisé en ce que ce dispositif comporte, pour réaliser ladite détection d'accrochage, des moyens (5) de détection d'accrochage comportant eux-mêmes des moyens (50) pour réaliser un échantillonnage du signal de sortie du détecteur d'écart de phase, par celles des transitions du signal sortant qui sont de type opposé audit type donné et pour mémoriser des groupes d'échantillons consécutifs, en nombre au moins égal à 3, et des moyens (54) de détection de l'instant où, pour la première fois, deux au moins desdits échantillons n'ont pas le même niveau logique.

means themselves including means (50) for sampling the output signal from the detector for detecting the phase difference by those transitions in the outgoing signal that are of type opposite to said given type, and for storing groups of consecutive samples, comprising not less than three consecutive samples, and means (54) for detecting the instant at which, for the first time, at least two of said samples are not at the same logic level.

## Patentansprüche

1. Vorrichtung zur Erfassung des Einrastens einer digitalen Phasenverriegelungsschleife (1), die einen Detektor zur Erfassung des Phasenabstands zwischen dem Eingangssignal und dem Ausgangssignal aufweist, wobei das Ausgangssignal dieses Phasenabstandsdetektors Übergänge eines ersten Typs gleichzeitig mit den Übergängen eines bestimmten Typs des Ausgangssignals sowie Übergänge eines zweiten Typs gleichzeitig mit den Übergängen eines bestimmten Typs des Eingangssignals besitzt, dadurch gekennzeichnet, daß die Vorrichtung für die Erfassung des Einrastens Mittel (5) zur Erfassung des Einrastens enthält, die ihrerseits Mittel (50), um eine Tastung des Ausgangssignals des Phasenabstandsdetektors mit denjenigen Übergängen des Ausgangssignals durchzuführen, die dem gegebenen Typ entgegengesetzt sind, und um Gruppen von mindestens drei aufeinanderfolgenden Tastproben zu speichern, sowie Mittel (54) zur Erfassung des Zeitpunkts aufweisen, in dem zum ersten Mal mindestens zwei dieser Tastproben nicht den gleichen logischen Pegel besitzen.

## Claims

1. A circuit for detecting locking of a digital phase locked loop, said phase locked loop (1) includes a detector for detecting the phase difference between said incoming signal and said outgoing signal, and the output signal from said phase difference detector has transitions of a first type in coincidence with transitions of a given type in the outgoing signal, and transitions of a second type in coincidence with transitions of a given type in the incoming signal, the circuit being characterized in that it includes locking detection means (5) for detecting locking, said

# FIG. 1

FIG. 2

# FIG. 3

EP 0 536 042 B1

# FIG. 4